Europäisches Patentamt

European Patent Office

Office européen des brevets

(19)

(11) Publication number: **0 127 369**
A2

(12) **EUROPEAN PATENT APPLICATION**

(21) Application number: **84303260.8**

(22) Date of filing: **15.05.84**

(51) Int. Cl.³: **H 01 G 1/10**
**H 05 K 5/06**

(30) Priority: **26.05.83 GB 8314608**

(43) Date of publication of application:
**05.12.84 Bulletin 84/49**

(84) Designated Contracting States:
**DE FR IT SE**

(71) Applicant: **STANDARD TELEPHONES AND CABLES PUBLIC LIMITED COMPANY**
**190 Strand**
**London, WC2R 1DU(GB)**

(72) Inventor: **Workman, Ernest James**
**7, Apton Road**
**Bishop's Stortford Hertfordshire(GB)**

(74) Representative: **Dennis, Mark Charles**
**STC Patent Department Edinburgh Way**
**Harlow Essex CM20 2SH(GB)**

(54) **Encapsulation process.**

(57) Electrical components, e.g. mica capacitors are encapsulated in an insulating resin. Adhesion of the resin is ensured by the provision of an intermediate pre-coat of a cured resin coating a filler and a plasticiser. Typically this precoat is an electrodeposited acrylic resin containing a barium titanate filler and a phthalate plasticiser. The encapsulating resin may be an injection moulded polyphenylene sulphide.

EP 0 127 369 A2

Croydon Printing Company Ltd.

## ENCAPSULATION PROCESS

This invention relates to the encapsulation of piece parts, e.g. electrical components, with insulating materials.

Electrical components, such as capacitors, integrated circuits and hybrid circuits, are conventionally provided with a protective coating of an encapsulant plastics material typically by a transfer moulding or injection moulding process. A major problem with all encapsulated components is that of preventing ingress of moisture through the encapsulation. In particular, the weak points of such a construction are seals between the plastics encapsulation and the component levels. Unless an effective seal between the plastics material and the metal leads can be provided moisture can enter the package along the lead wires resulting in impairment and possible ultimate failure of the component.

The object of the present invention is to minimise or to overcome this disadvantage.

According to one aspect of the invention there is provided a process for treating a leaded component prior to encapsulation with an insulating material, characterised in that at least those portions of the leads adjacent the component are electrocoated with an adherent precoat of a plastics resin whereby an hermetic seal between the resin and the component leads is provided.

According to another aspect of the invention there is provided a process for encapsulating a component with an insulating material, characterised in that at least the conductive portions of the component surface are electrocoated with an adherent pre-coat of a curable resin, and that an encapsulating coating of the insulating material is applied to the current resin.

According to a further aspect of the invention there is provided an encapsulated component provided with a first adherent pre-coat of a cured resin containing a plasticiser and a second encapsulating coating of an insulating material.

Where the encapsulating resin is a thermoplastics material the waste from the encapsulation process can be recycled. This provides a significant cost reduction over many present encapsulation processes which employ transfer moulding techniques.

The pre-coat provides an hermetic seal between the encapsulation and the component, in particular the component leads or terminals. It is thought that the inclusion of a plasticiser in the material gives it resilience to enhance the necessary sealing effect. Advantageously the pre-coat also contains a filler.

Typically we apply the pre-coating resin by an electrodeposition process such as those described in our copending application No. 8210134 (H.F. Sterling-E.L. Bush-J.H. Alexander 85-26-19).

The process is particularly suitable for encapsulating capacitors, e.g. mica capacitors or multilayer ceramic capacitors, but is not of course limited to these devices.

In a typical process capacitors are pre-coated with an acrylic resin or an epoxy resin. This resin preferably contains a plasticiser and optionally a filler. We prefer to employ a combination of barium titanate and a phthalate plasticiser, e.g. benzyl butyl phthalate, but other plasticisers or combinations of filler and plasticiser can of course be employed. The pre-coat may be applied by a variety of methods including electrocoating, dip coating and spraying. Electrocoating is however the preferred technique as it produces uniform and reproducible results.

In this process capacitors to be pre-coated are immersed in a tank containing the electrocoating material and an electric potential, e.g. 100 to 200 volts, is applied to effect deposition. This process is self limiting as the deposition ceases as soon as a uniform thickness dependent on the applied voltage has been obtained. The process is also self healing as any pinholes in the coating are immediately filled with deposited material. Advantageously the coating medium also contains a wetting agent/surfactant such as SURFYNOL.

In an alternative process the capacitors may be dip coated or sprayed with the resin mixture.

After coating has been effected the deposited material is cured to form a firmly adherent cross-linked pre-coating on the capacitor. Typically we employ oven curing but any other suitable technique, for example the use of ultraviolet light or ionising radiation, may of course be used.

After curing of the pre-coating the capacitors are then coated e.g. with an injection moulded layer of a thermoplastics material to provide the encapsulation. Advantageously a polyphenylene sulphide is used for this purpose. The pre-coat provides an hermetic seal between the capacitor and the thermoplastics material and thus ensures the integrity of the encapsulant coating.

Other encapsulation processes including resin dipping, casting or transfer moulding may be employed to provide the encapsulation. Also the encapsulation may comprise any suitable plastics material.

In a typical encapsulation process we use an acrylic ME1420 resin as the precoat material. The material is prepared by adding to 400g of the resin 80ml benzyl butyl phthalate, 32ml SURFYNOL and 16ml butyl alcohol. The mix is stirred until an homogeneous material is obtained. 300g barium titanate are added slowly to the mix together with up to 150ml distilled water. A further 300g quantity of barium titanate is added followed by 50ml water. 200g Ottowa sand is next added and the composition is milled for 3 Hrs. A further 400g resin is added and the composition is milled for a further $1\frac{1}{2}$ hours.

After milling is complete the composition is filtered to remove the sand and is stirred for up to 12 hours to remove dissolved gases. The material is then ready for application to components by an electrocoating technique.

The following example illustrates the invention.

A batch of mica capacitors was divided into four groups each of which was either dip coated with Elvacite or electrocoated with an acrylic or an epoxy resin to provide a tie coat on the mica stack. The Elvacite and epoxy resins were employed for comparative purposes without filler or plasticiser. The acrylic resin contained a barium titanate filler and a dioctylphthalate plasticiser. Each batch was then encapsulated by injection moulding in a 'Ryton' polyphenylene sulphide resin type BR61A. The four groups are identified as follows:

| Group | Capacitance pF | Volting Rating | Pre-Coat |
|-------|----------------|----------------|----------|
| A | 2500 | 400 | Elvacite |
| B | 2500 | 400 | Acrylic |
| C | 2500 | 400 | Epoxy |
| D | 5500 | 400 | Elvacite |

All samples were air dried at $85^{\circ}$C for 6 Hrs and the leakage current was measured. They were then subjected to a solvent test by further heating at $85^{\circ}$C in air for 1 Hr followed by immersion in methanol for half an hour, analysing and remeasuring of the leakage current. A significant rise in leakage indicated an encapsulation fault allowing the ingress of solvent. In all cases measurements were carried out at 12 volts with a 1 minute charge time. A leakage current limit of 0.48 nanoamp was used.

This solvent test is more fully described in our copending European patent application No. 83301113.3 (R.C. Chittick 2Y).

The results of this solvent testing are summarised in Tables 1 to 5 below. As can be seen of the four groups only the electrocoated acrylic pre coat showed no insulation failures. This indicates that an acrylic pre coat provides good adhesion to the lead wires and is also compatible with the encapsulating resin. The capacitors were also subjected to 21 day and 56 day accelerated life tests with and without applied volts and the results are summarised in Tables 6 and 7 below. As can be seen only those capacitors provided with the plasticised pre-coat as described herein exhibited a consistantly high quality.

Whilst the process has been described with particular reference to capacitors it will be clearly understood that the term 'component' is not so limited. Thus the process may also be applied e.g. to integrated circuits, discrete semiconductors and to circuit assemblies.

## TABLE 1 - Elvacite

| Sample | Leakage Current - nano amps | |
| | Original | After MeOH |
|---|---|---|
| 11A | 0.009 | 1120 |
| 12A | 0.008 | 0.008 |
| 13A | 0.008 | 742 |
| 14A | 0.009 | 452 |
| 15A | 0.012 | 0.013 |
| 16A | 0.010 | 43.1 |
| 17A | 0.010 | 0.008 |
| 18A | 0.010 | 465 |
| 19A | 0.013 | 0.012 |
| 20A | 0.012 | 487 |
| 11B | 0.009 | 680 |
| 12B | 0.009 | 0.009 |
| 13B | 0.009 | 683 |
| 14B | 0.009 | 0.006 |
| 15B | 0.012 | 695 |
| 16B | 0.012 | 0.009 |
| 17B | 0.010 | 155 |
| 18B | 0.013 | 635 |
| 19B | 0.008 | 490 |
| 20B | 0.013 | 0.011 |

## TABLE 2 - Acrylic

| | Leakage Current - nano amps | |
| Sample | Original | After MeOH |
|--------|----------|------------|
| 28A | 0.010 | 0.010 |
| 29A | 0.008 | 0.006 |
| 30A | 0.012 | 0.010 |
| 31A | 0.010 | 0.007 |
| 32A | 0.011 | 0.008 |
| 33A | 0.011 | 0.006 |
| 34A | 0.013 | 0.010 |
| 36A | 0.012 | 0.007 |
| 37A | 0.008 | 0.006 |
| 38A | 0.008 | 0.006 |
| 28B | 0.009 | 0.008 |
| 29B | 0.012 | 0.008 |
| 30B | 0.009 | 0.007 |
| 31B | 0.010 | 0.007 |
| 32B | 0.010 | 0.007 |
| 33B | 0.010 | 0.008 |
| 34B | 0.009 | 0.008 |
| 36B | 0.008 | 0.004 |
| 37B | 0.010 | 0.006 |
| 38B | 0.008 | 0.005 |

## TABLE 3 - Epoxy

| | Leakage Current - nano amps | |
| Sample | Original | After MeOH |
|--------|----------|------------|
| 43A | 0.008 | 0.021 |
| 44A | 0.008 | 832 |
| 45A | 0.009 | 675 |
| 46A | 0.010 | 662 |
| 47A | 0.009 | 970 |
| 48A | 0.012 | 12.3 |
| 49A | 0.010 | 75.2 |
| 50A | 0.010 | 576 |
| 51A | 0.011 | 237 |
| 52A | 0.010 | 0.008 |
| 43B | 0.007 | 574 |
| 44B | 0.009 | 0.010 |
| 45B | 0.010 | 965 |
| 46B | 0.013 | 10.2 |
| 47B | 0.013 | 65.6 |
| 48B | 0.009 | 0.008 |
| 49B | 0.009 | 142 |
| 50B | 0.010 | 792 |
| 51B | 0.011 | 932 |
| 52B | 0.008 | 0.008 |

## TABLE 4 - Elvacite

| Sample | Leakage Current - nano amps | |
| | Original | After MeOH |
| --- | --- | --- |
| 70A | 0.049 | 0.048 |
| 71A | 0.050 | 56.1 |
| 72A | 0.044 | 0.042 |
| 73A | 0.047 | 0.048 |
| 74A | 0.048 | 0.050 |
| 75A | 0.048 | 0.048 |
| 76A | 0.048 | 0.046 |
| 77A | 0.051 | 117 |
| 78A | 0.050 | 0.048 |
| 79A | 0.050 | 0.049 |
| 70B | 0.050 | 0.051 |
| 71B | 0.053 | 0.053 |
| 72B | 0.053 | 0.053 |
| 73B | 0.052 | 0.048 |
| 74B | 0.043 | 0.039 |
| 75B | 0.054 | 0.053 |
| 76B | 0.050 | 0.050 |
| 77B | 0.046 | 0.044 |
| 78B | 0.053 | 0.052 |
| 79B | 0.050 | 632 |

## TABLE 5 - Elvacite

| | Leakage Current - nano amps | |
| Sample | Original | After MeOH |
|--------|----------|------------|
| 57A | 0.030 | 0.030 |
| 58A | 0.029 | 0.027 |
| 59A | 0.028 | 0.029 |
| 60A | 0.031 | 0.030 |
| 62A | 0.032 | 0.032 |
| 63A | 0.048 | 0.056 |
| 64A | 0.042 | 574 |
| 65A | 0.026 | 0.028 |
| 66A | 0.030 | 0.030 |
| 67A | 0.029 | 0.030 |
| 57B | 0.028 | 0.028 |
| 58B | 0.029 | 0.030 |
| 59B | 0.034 | 0.035 |
| 60B | 0.036 | 355 |
| 62B | 0.040 | 0.110 |
| 63B | 0.038 | 976 |
| 64B | 0.028 | 0.027 |
| 65B | 0.036 | 0.037 |
| 66B | 0.029 | 0.030 |
| 67B | 0.030 | 0.040 |

## TABLE 6
### without applied volts

| Sample | MeOH Test Pass | MeOH Test Fail | % Failure MeOH Test | % Failure LTDH Test 21 day | % Failure LTDH Test 56 day |
|---|---|---|---|---|---|
| Group A - Elvacite | 8 | 12 | 60 | 0 | 10 |
| Group B - Acrylic | 20 | - | 0 | 0 | 0 |
| Group C - Epoxy | 5 | 15 | 75 | 0 | 90 |
| Group D - Elvacite | 34 | 6 | 15 | 0 | 15 |

## TABLE 7
### with applied volts

| Sample | MeOH Test Pass | MeOH Test Fail | % Failure MeOH Test 21 day | % Failure LTDH Test 56 day | |
|---|---|---|---|---|---|
| Group A - Elvacite | 8 | 12 | 60 | 20 | 45 |
| Group B - Acrylic | 20 | - | 0 | 0 | 5 |
| Group C - Epoxy | 5 | 15 | 75 | 45 | 90 |
| Group D - Elvacite | 34 | 6 | 15 | 5 | 27.5 |

0127369

The term component as employed herein is understood to include, but is not limited to, capacitors, resistors and integrated circuits. It is also understood to include piece parts for such components, e.g. integrated circuit lead furnaces.

CLAIMS:-

1.      A process for treating a leaded component prior to encapsulation with an insulating material, characterised in that at least those portions of the leads adjacent the component are electrocoated with an adherent precoat of a plastics resin whereby an hermetic seal between the resin and the component leads is provided.

2.      A process for encapsulating a component with an insulating material, characterised in that at least a portion of the component surface is electrocoated with an adherent precoat of a curable resin, and that an encapsulating coating of the insulating material is applied to the current resin.

3.      A process as claimed in claim 2, characterised in that the pre-coat contains a filler.

4.      A process as claimed in claim 3, characterised in that the filler is barium titanate.

5.      A process as claimed in claim 2, 3 or 4, characterised in that the precoat contains a plasticiser.

6.      A process as claimed in claim 5, characterised in that the plasticiser is benzyl butyl phthalate.

7.      A process as claimed in any one of claims 2 to 6, characterised in that the precoat comprises an acrylic based resin system or an epoxy resin system.

8.      A process as claimed in any one of claims 2 to 7, characterised in that the insulating material is a thermoplastics resin.

9.      A process as claimed in claim 8, characterised in that the thermoplastics resin is applied to the component by injection moulding.

10.     A process as claimed in any one of claims 2 to 7, characterised in that the insulating material is applied by resin dipping, transfer moulding or casting.

11.     A process as claimed in claim 2, characterised in that the component is treated with a surfactant prior to or during electrocoating.

12. A process as claimed in any one of claims 1 to 11, characterised in that the encapsulating coating is a polyphenylene sulphide.

13. A process as claimed in any one of claims 1 to 12, characterised in that the component is a mica or a ceramic capacitor.

14. A process for encapsulating a capacitor with an insulating material, characterised in that the exposed conductive portions of the capacitor are electrocoated with an acrylic resin containing a filler and a plasticiser, curing the acrylic resin, and that an encapsulating coating of an insulating material is subsequently applied to the capacitor.

15. An encapsulated component provided with a first adherent pre-coating of a cured resin containing a plasticiser and a second encapsulating coating of an insulating material.

16. An encapsulated component as claimed in claim 15, characterised in that said precoating contains a filler.

17. A capacitor provided with an encapsulating coating, comprising a first adherent pre-coat of an acrylic resin coating a barium titanate filler and a phthlate plasticiser, and a second encapsulating coat of a plastics resin.

18. A capacitor as claimed in claim 17, characterised in that the second coat comprises polyphenylene sulphide.

19. A capacitor as claimed in claim 17 or 18 and comprising a mica capacitor or a ceramic capacitor.

20. A component encapsulated by a process as claimed in any one of claims 2 to 14.

21. A capacitor having external connection terminals and encapsulated in a plastics material which has been injection moulded around the capacitor, characterised in that an adherent electro-coat of an insulating material is applied to the connection terminals to effect sealing between the terminals and the moulded plastics material.